# EUROPÄISCHE PATENTSCHRIFT

(11) **EP 3 488 472 B1**
(45) Veröffentlichungstag und Bekanntmachung des Hinweises auf die Patenterteilung: **14.07.2021**
(21) Anmeldenummer: 17748394.8
(22) Anmeldetag: 15.07.2017
(51) Int. Cl.: H01L 31/02, H01L 31/048, H01L 31/054, G02B 19/00

(54) **SOLARZELLENMODUL**
SOLAR CELL MODULE
MODULE DE CELLULES SOLAIRES

(30) Priorität: 21.09.2016 DE 102016011321
(43) Veröffentlichungstag der Anmeldung: 29.05.2019
(73) Patentinhaber: AZUR SPACE Solar Power GmbH, 74072 Heilbronn (DE)
(72) Erfinder: LÖCKENHOFF, Rüdiger, 74321 Bietigheim-Bissingen (DE)
(74) Vertreter: Koch Müller Patentanwaltsgesellschaft mbH
(86) Internationale Anmeldenummer: PCT/EP2017/000850
(87) Internationale Veröffentlichungsnummer: WO 2018/054510

(56) Entgegenhaltungen:
- US-A1- 2008 083 450
- US-A1- 2011 067 758
- ANDREEV V M ET AL: "DEVELOPMENT OF PV RECEIVERS FOR SPACE LINE-FOCUS CONCENTRATOR MODULES", CONFERENCE RECORD OF THE 25TH. IEEE PHOTOVOLTAIC SPECIALISTS CONFERENCE 1996. WASHINGTON, MAY 13 - 17, 1996; [CONFERENCE RECORD OF THE IEEE PHOTOVOLTAIC SPECIALISTS CONFERENCE], NEW YORK, IEEE, US, Bd. CONF. 25, Nr. CONF. 25, 13. Mai 1996 (1996-05-13), Seiten 341-344, XP000896925, ISBN: 978-0-7803-3167-9

## Beschreibung

Die Erfindung betrifft ein Solarzellenmodul.

Solarzellenempfänger, wie sie beispielsweise aus der WO 2014/019652 A1 oder der EP 2 073 279 A1 bekannt sind, weisen typischerweise einen auf einem Träger angeordneten als Solarzelle ausgebildeten Halbleiterkörper und ein auf der Empfangsfläche des Halbleiterkörper angeordnetes sekundäres optisches Element zumeist in Form einer Linse auf. Weitere Solarzellenmodule sind aus "Development of PV Receivers for Space Line-Focus Concentrator Modules", V.M. Andreev et al., Converence Records of the 25th IEEE Photovoltaic Specialists Conference, 1996, S. 341-344, XP000896925, ISBN: 978-0-7803-3167-9, sowie aus der US 2008/0083450 A1 und der US 2011/0067758 A1 bekannt.

Zur elektrischen Kontaktierung weist der Halbleiterkörper einen ersten und einen zweiten Anschlusskontakt auf, wobei jeder Anschlusskontakt mit einer auf dem Träger angeordneten Kontaktfläche, z. B. einem Leiterbahnbereich, elektrisch verbunden ist.

Um Sonnenlicht auf die Oberfläche der Solarzelle zu leiten ist oberhalb der des sekundären optischen Elements ein primäres optisches Element in Form einer Fresnel Linse angeordnet. Ein derartiges System wird auch als CPV System bezeichnet. Die Konzentrationsfaktoren für das Sonnenlicht betragen oberhalb 50. Im Allgemeinen werden als Solarzellen Mehrfachsolarzellen verwendet.

In einem Modul sind mehrere Solarzellenempfänger zumeist auf einer metallischen Grundplatte zueinander beabstandet angeordnet. Die Solarzellenempfänger sind hierbei im Allgemeinen in Serie verschaltet.

Das Modul ist vollständig umschlossen, um die in dem Modul angeordneten Solarzellenempfänger vor Umwelteinflüssen zu schützen.

Vor diesem Hintergrund besteht die Aufgabe der Erfindung darin, eine Vorrichtung anzugeben, die den Stand der Technik weiterbildet.

Die Aufgabe wird durch ein Solarzellenmodul mit den Merkmalen des Patentanspruchs 1 gelöst. Vorteilhafte Ausgestaltungen der Erfindung sind Gegenstand von Unteransprüchen.

Insbesondere ist eine besondere Aufgabe die elektrische Isolation der Solarzelleneinheiten im Modul von der Grundplatte, welche die Solarzelleneinheiten trägt. Die einschlägige Norm IEC62108 fordert hier je nach Systemspannung eine Isolations-Prüfspannung von mehreren Tausend Volt.

Gemäß dem Gegenstand der Erfindung wird ein Solarzellenmodul aus mehreren auf einer Oberfläche einer metallischen oder überwiegen metallischen Grundplatte angeordneten Solarzelleneinheiten bereitgestellt.

Jede Solarzelleneinheit weist einen Träger mit einer Oberseite und einer Unterseite, einen auf der Oberseite des Trägers angeordneten und als Solarzelle ausgebildeten Halbleiterkörper und ein auf dem Halbleiterkörper angeordnetes sekundäres optisches Element auf.

Die auf der Oberseite des Trägers angeordneten Teile der Solarzelleneinheit überragen bzw. stehen seitlich über den Träger nicht hinaus.

Der Träger ist plattenförmig ausgebildet und weist vorzugsweise eine geschlossene Oberfläche ohne Löcher auf.

Der Träger jeder Solarzelleneinheit überdeckt jeweils einen ersten Bereich der Oberfläche der Grundplatte.

Die Unterseite jedes Trägers ist mittels eines wärmeleitfähigen und elektrisch isolierenden Haftmittels kraftschlüssig mit dem ersten Bereich der Oberfläche der Grundplatte verbunden ist.

Weiterhin ist um jeden Träger ein den Träger in einer senkrecht zu der Oberfläche der Grundplatte verlaufenden Projektion vollständig umschließender zweiter Bereich der Oberfläche der Grundplatte vollständig mit dem Haftmittel bedeckt.

Das Haftmittel weist in dem ersten Bereich und in dem zweiten Bereich im Wesentlichen eine einheitliche Schichtdicke auf.

Der Unterschied der Schichtdicke des Haftmittels ist zwischen dem ersten Bereich und dem zweiten Bereich kleiner als 20%, höchst vorzugsweise kleiner als 10% und insbesondere kleiner als 5%.

Es versteht sich, dass die Schichtdicke des Haftmittels in dem ersten Bereich und in dem zweiten Bereich bei dem Auftragen des Haftmittels gleich groß ist und die Schichtdicke des Haftmittels in dem ersten Bereich durch den Fügeprozess der Solarzelleneinheit mit der Unterlage sich potentiell etwas verringert.

Anders ausgedrückt, das Haftmittel überdeckt die seitliche Kante des Trägers wenn überhaupt, jedoch keinesfalls vollständig. Vorzugsweise wird die seitliche Kante des Trägers von dem Haftmittels nicht überdeckt.

Vorzugsweise ist der Träger an der Unterseite vollständig mit dem Haftmittel bedeckt. Es versteht sich, dass der Träger mit der Grundplatte ausschließlich mit dem Haftmittel kraftschlüssig verbunden ist. Anders ausgedrückt, weitere Befestigungsmittel für eine Fixierung des Trägers an der Grundplatte sind nicht vorgesehen.

Vorzugsweise ist an der Unterseite des Trägers eine stoffschlüssig mit dem Träger verbundene Metallschicht ausgebildet, um insbesondere die thermische Ankopplung des Trägers an die Grundplatte zu erhöhen. Es versteht sich, dass der Träger an der Unterseite zumindest in einen umlaufenden Randbereich von kleiner als 0,5 mm keine Metallschicht aufweist.

Vorzugsweise sind bis auf eine mögliche Metallschicht an der Unterseite des Trägers keine weiteren Teile der Solarzelleneinheit angeordnet.

Vorzugsweise ist auf der Oberseite das insbesondere aus einem Glas bestehende sekundäre optische Element nur mittels eines organischen Mittels, insbesondere einer Polymerkleberschicht, mit dem Träger und der Solarzelle kraftschlüssig verbunden. Weitere Befestigungsmittel sind für das sekundäre optische Element nicht vorgesehen. Das sekundäre optische Element weist hierbei eine vollständig plane Unterseite auf.

Es sei angemerkt, dass es sich bei der Solarzelle vorzugsweise um eine III-V Halbleitersolarzelle auf GaAs oder Ge- Basis handelt und die Solarzelle höchst vorzugsweise als stapelförmig angeordnete Mehrfachsolarzelle ausgebildet ist und unter anderem mittels Nutzung von UV-Lichtanteilen Wirkungsgrade oberhalb 30% aufweist.

Derartige Solarzelleneinheiten werden, unter anderem wegen den im Vergleich zu den Siliziumsolarzellen höheren Herstellkosten, bevorzugt in CPV-Systemen eingesetzt. Das mittels eines primären optischen Konzentrators bzw. Elements gebündelte Licht auf das sekundäre optische Element der Solarzelleneinheit geleitet.

Das primäre Element, beispielsweise eine Fresnel-Linse, ist oberhalb des sekundären optischen Elements angeordnet. Von dem sekundären optischen Element wird das Licht entlang der optischen Achse zu der Polymerkleberschicht geleitet, um die Polymerkleberschicht zu durchdringen und auf die Vorderseite des Halbleiterkörpers, der Solarzelle, zu fallen.

Ein elektrischer Kontakt mit der Solarzelleneinheit wird über auf der Trägeroberfläche angeordneten Kontaktflächen hergestellt Die Kontaktflächen werden beispielsweise durch Widerstandspunktschweißen mit einem metallischen Verbindungselement elektrisch verbunden.

In einer Weiterbildung ist das Verbindungselement mit dem wenigstens zwei benachbarte Solarzelleneinheiten miteinander in Serie verschaltet sind als ein bügelartiger Schaltdraht ausgeführt. Vorzugsweise umfasst oder besteht der Schaltdraht aus einem einzelnen Runddraht, aus einem massiven Metallband oder aus mehreren Adern.

Der Schaltdraht ist mit den Kontaktflächen kraftschlüssig verbunden und stellt eine elektrische Verbindung mit den Kontaktflächen her.

Vorzugsweise ist der Schaltdraht u-förmig ausgebildet und weist an jedem Ende eine parallel zu der Oberfläche des Trägers ausgebildeter Anschlussbereich auf.

In einer Weiterbildung weist der Schaltdraht keine isolierende Ummantelung auf, anders ausgedrückt der Schaltdraht weist auf der gesamten Länge eine Metalloberfläche gegen Luft auf.

In einer anderen Weiterbildung umfasst der Schaltdraht einen Querschnitt von wenigstens 0,5 mm², vorzugsweise 0,8 mm² und höchst vorzugsweise einen Querschnitt von 2,5 mm² auf. Vorzugsweise liegt der Querschnitt des Schaltdrahtes in einem Bereich zwischen 0,3 mm² und 5,0 mm².

In einer Ausführungsform beträgt der Abstand des Schaltdrahts in dem Bereich, vorzugsweise in einem mittleren Bereich, des Bügels zu der Oberseite der Grundplatte wenigstens 2 mm.

In einer anderen Ausführungsform sind auf den Kontaktflächen Metallfahnen angeordnet. Die Metallfahnen sind vorzugsweise abgewinkelt.

Ein Vorteil der erfindungsgemäßen Vorrichtung ist es, dass eine zuverlässige elektrisch Isolation der einzelnen Solarzelleneinheiten ohne zusätzlichen Prozessschritt erreicht wird.

Untersuchungen haben gezeigt, dass sich durch den elektrisch isolierenden Rahmen, d.h. den zweiten Bereich, um die einzelnen Solarzelleneinheiten insbesondere Kurzschlüsse durch eine Benetzung der Oberfläche beispielsweise mit Kondenswasser verhindern lassen. Der Rahmen bildet eine sogenannte Kriechstrecke gegen Luft für Umgebungen mit zeitweiliger Kondensation aus.

In bisherigen Lösungen ist die Kriechstrecke, d.h. der Rahmen separat angeordnet, d.h. der Rahmen weist ein anderes ein sogenanntes "conformal coating" Material auf, als die Wärmeleitpaste unterhalb der Unterseite der jeweiligen Solarzelleneinheit.

Eine wichtige erfinderische Einsicht ist, dass sich das Haftmittel höchst vorteilhaft in einem einzigen Prozessschritt gleichzeitig auf dem ersten Bereich und dem zweiten Bereich abscheiden lässt, so dass sich eine zusammenhängende mit Haftmittel überdeckte Haftmittel-Gesamtfläche auf der Grundplatte ausbildet.

Die Haftmittel-Gesamtfläche hat im ersten Flächenbereich die Funktion, eine stoffschlüssige und wärmeleitende Verbindung zwischen der Unterseite des Solarzellenelement und der Oberseite der Grundplatte herzustellen. Im zweiten Flächenbereich hat sie die Funktion, einen elektrisch isolierenden Rahmen als Kriechstrecke gegen Luft herzustellen.

In einer anderen Weiterbildung umfasst die Grundplatte einen metallischen Werkstoff oder besteht aus einem Metall. Neben der mechanischen Stabilität der Grundplatte ist eine gute Wärmleitfähigkeit vorteilhaft, um als Kühlkörper für die einzelnen Solarzelleneinheiten zu wirken.

Des Weiteren sei ausgeführt, dass für die Verbindung des sekundären optischen Elements mit der Solarzelle auf dem Klebstoff kein weiteres Haftmittel notwendig ist.

Gemäß einer Weiterbildung weist jeder zweite Bereich einen an den Träger angrenzenden inneren Rand und einen den zweiten Bereich umschließenden äußeren Rand auf, wobei eine parallel zu der Oberfläche der Grundplatte gemessene Breite zwischen dem inneren Rand und dem äußeren Rand mindestens 5 mm. Gemäß dem Gegenstand der Erfindung beträgt die Breite des zweiten Bereichs mindestens 3 mm.

In einer anderen Ausführungsform weist das den zweiten Bereich bedeckende Haftmittel eine Höhe über der Oberfläche der Grundplatte von mindestens 0,05 mm auf.

Gemäß einer weiteren Ausführungsform umfasst oder besteht der Träger jeder Solarzelleneinheit ein keramisches Material und /oder einen elektrisch isolierten Metallkern auf.

In einer anderen Ausführungsform weist der Träger jeder Solarzelleneinheit eine von mindestens vier Kanten umschlossene, vorzugsweise plane Oberseite auf, wobei mindestens zwei, insbesondere drei Kontaktflächen entlang einer ersten Kante auf der Oberseite des Trägers angeordnet sind und der Halbleiterkörper zwischen den mindestens zwei Kontaktflächen und einer der ersten Kante gegenüberliegenden Kante angeordnet ist.

Es versteht sich, dass an der Oberseite des Trägers Leiterbahnen ausgebildet sind, um den Strom der Solarzelle an die Kontaktfläche zu transportieren. Vorzugsweise sind die Kontaktflächen mit den Leiterbahnen einstückig ausgebildet. Vorzugsweise überdecken die Leiterbahnen zusammen mit den Kontaktflächen mehr als 70 % der Oberseite des Trägers, um eine möglich gute Wärmeverteilung auf dem Träger zu erzielen.

Vorzugsweise ist an der Oberseite des Trägers in einem umlaufenden Randbereich von wenigstens 0,5 mm Abstand zum Rand keine Leiterbahnen oder Kontaktflächen ausgebildet.

Durch die ausschließlich einseitige Anordnung der Kontaktflächen kann die Größe des Trägers im Vergleich zu einer Anordnung an gegenüberliegenden Kanten des Trägers deutlich reduziert werden.

Gemäß einer weiteren Ausführungsform ist das sekundäre optische Element jeder Solarzelleneinheit linsenförmig mit einer dem Halbleiterkörper abgewandten konvexen Oberfläche oder trichterförmig ausgebildet.

Gemäß einer bevorzugten Weiterbildung weist das sekundäre optische Element jeder Solarzelleneinheit vier Ausbuchtungen auf, wobei die Ausbuchtungen in einer ersten Dicke über einer vorzugsweise planen Unterseite auf einem seitlichen Oberflächenbereich des jeweiligen sekundären optischen Elements angeordnet sind, in einer senkrecht zu der Unterseite verlaufenden Projektion über die Unterseite hinausragen und entlang eines parallel zu der Unterseite des optischen Elements verlaufenden Umfangs des sekundären optischen Elements gleichmäßig verteilt sind.

Besonders bevorzugt ist die Oberseite des Trägers jeder Solarzelleneinheit von vier Kanten begrenzt und das sekundäre optische Elemente jeder Solarzelleneinheit so auf dem Träger der Solarzelleneinheit angeordnet ist, dass eine zwei einander gegenüberliegende Ausbuchtungen verbindende Gerade mit den Kanten der Oberseite des Trägers einen Winkel zwischen 35° und 55° einschließt. Die Unterseite der Ausbuchtungen sind von der Unterseite des sekundären optischen Elements mittels einer ersten Höhe beabstandet.

Die Erfindung wird nachfolgend unter Bezugnahme auf die Zeichnungen näher erläutert. Hierbei werden gleichartige Teile mit Identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine schematische Ansicht auf eine erste erfindungsgemäße Ausführungsform eines Solarzellenmoduls,
- Figur 2: eine schematische Ansicht eines detaillierteren Ausschnitts des Solarzellenmoduls gemäß Figur 1,
- Figur 3: einen Ausschnitt einer zweiten Ausführungsform eines Solarzellenmoduls,
- Figur 4: Querschnittsansicht auf einen Drahtverbinder mit einer Ausschnittsvergrößerung.

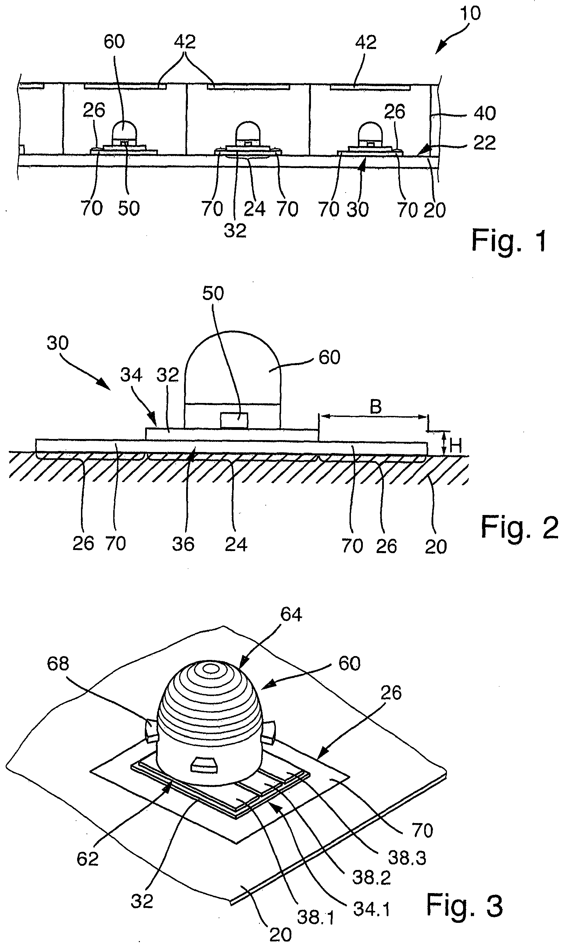

Die Abbildung der Figur 1 zeigt eine Ansicht einer ersten Ausführungsform eines Solarzellenmoduls 10. Ein detaillierterer Ausschnitt der ersten Ausführungsform des Solarzellenmoduls 10 ist in der Abbildung der Figur 2 gezeigt.

Das Solarzellenmodul 10 weist eine metallische Grundplatte 20 mit einer Oberfläche 22, mehrere auf der Oberfläche 22 der Grundplatte 20 angeordnete Solarzelleneinheiten 30 sowie einen auf der Oberfläche 22 der Grundplatte 20 angeordnetes Gerüst bzw. einen Tragrahmen 40 mit mehreren parallel zu der Oberfläche 22 der Grundplatte 20 und zu dieser beabstandeten gehaltenen primären optischen Elementen 42 auf.

Jede Solarzelleneinheit 30 weist einen eine Keramik umfassenden Träger 32 mit einer Oberseite 34 und einer Unterseite 36, einen auf der Oberseite 34 des Trägers 32 angeordneten und als Solarzelle ausgebildeten Halbleiterkörper 50 und ein auf dem Halbleiterkörper 50 angeordnetes sekundäres optisches Element 60 aufweist. Das sekundäre optische Element 60 ist mittels einer nicht dargestellten Polymerschicht mit der Oberseite 34 des Trägers 32 kraftschlüssig verbunden.

Der Träger 32 jeder Solarzelleneinheit 30 überdeckt jeweils einen ersten Bereich 24 der Oberfläche 22 der Grundplatte 20. Die Unterseite 36 jedes Trägers 32 ist mittels eines wärmeleitfähigen und elektrisch isolierenden Haftmittels 70 kraftschlüssig mit dem ersten Bereich 24 der Oberfläche 22 der Grundplatte 20 verbunden. Darüber hinaus ist jeweils ein den Träger 32 in einer senkrecht zu der Oberfläche 22 der Grundplatte 20 verlaufenden Projektion vollständig umschließender zweiter Bereich 26 der Oberfläche 22 der Grundplatte 20 vollständig mit dem Haftmittel 70 bedeckt ist. Dabei weist der zweite Bereich 26 eine Breite B auf, wobei die Breite zwischen einem an den Träger 32 angrenzenden inneren Rand zu einem äußeren Rand gemessen wird. Das den zweiten Bereich 26 bedeckende Haftmittel 70 weist eine Dicke H über der Oberfläche 22 der Grundplatte 20 auf.

In der Abbildung der Figur 3 ist ein Ausschnitt des Solarzellenmoduls in einer weiteren Ausführungsform dargestellt. Im Folgenden werden nur die Unterschiede zu den Abbildungen der Figuren 1 und 2 erläutert. Die dargestellte Solarzelleneinheit 30 weist einen Träger 32 mit drei länglichen Kontakteflächen 38.1, 38.2, 38.3 auf, wobei die Kontaktflächen 38.1, 38.2, 38.3 Reihenfolge entlang einer ersten Kante 34.1 der Oberseite 34 des Träger 32 aufgereiht sind. Das sekundäre optische Element 60 weist eine konvexe Oberseite 64 und zwischen der Oberseite 64 und der planen Unterseite 62 eine zylinderförmige seitliche Oberfläche mit vier flügelförmige Ausformungen 68 auf. Die Ausformungen 68 sind jeweils zu der Unterseite 62 beabstandet und entlang eines parallel zu der Unterseite 62 verlaufenden Umfangs gleichmäßig verteilt. Jeweils eine Ausformung 68 ist in Richtung einer Ecke des Trägers 32 ausgerichtet bzw. die Ausformungen 68 sind so angeordnet, dass eine jeweils zwei gegenüberliegende Ausformungen 68 verbindende Gerade einen Winkel von 45° zu der ersten Kante 34.1 aufweist.

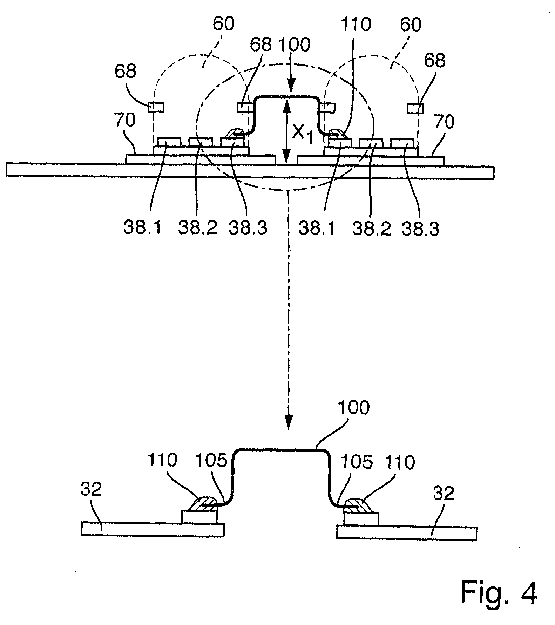

In der Abbildung der Figur 4 ist eine Querschnittsansicht auf einen Drahtverbinder und eine Ausschnittsvergrößerung dargestellt. Im Folgenden werden nur die Unterschiede zu den vorangegangenen Abbildungen erläutert. Ein Drahtbügel 100 mit jeweils abgekanteten Endstücken 105 stellt eine elektrische Verbindung zwischen zwei unmittelbar benachbarten Solarzelleneinheiten 32 her. In einem mittleren Bereich weist der Drahtbügel einen Abstand von X1 auf, wobei der Abstand X1 größer als 2 mm ist.

Auf den Kontaktflächen 38.1, 38.2, und 38.3 sind jeweils Lotdepot 110 angeordnet. Mittels des Lotdepots und Temperatur werden die Drahtenden mit den Kontaktflächen verbunden.

## Patentansprüche

1. Solarzellenmodul (10), aus mehreren auf einer Oberfläche (22) einer metallischen oder überwiegend metallischen Grundplatte (20) angeordneten Solarzelleneinheiten (30), wobei
- jede Solarzelleneinheit (30) einen Träger (32) mit einer Oberseite (34) und einer Unterseite (36), einen auf der Oberseite (34) des Trägers (32) angeordneten und als Solarzelle ausgebildeten Halbleiterkörper (50) und mehrere Kontaktflächen und ein auf dem Halbleiterkörper (50) angeordnetes sekundäres optisches Element (60) aufweist,
wobei die auf der Oberseite (34) des Trägers (32) oder an der Unterseite (36) des Trägers (32) angeordneten Teile der Solarzelleneinheit (30) den Träger seitlich nicht überragen,
wobei der Träger (32) plattenförmig ausgebildet ist,
- wobei der Träger (32) jeder Solarzelleneinheit (30) jeweils einen ersten Bereich (24) der Oberfläche (22) der Grundplatte (20) überdeckt und die Unterseite (36) jedes Trägers (32) mittels eines wärmeleitfähigen und elektrisch isolierenden Haftmittels (70) kraftschlüssig mit dem ersten Bereich (24) der Oberfläche (22) der Grundplatte (20) verbunden ist,
- wobei die jeweilige Solarzelleneinheit (30) nur in dem ersten Bereich kraftschlüssig mit der Grundplatte (20) verbunden ist, und
ein den Träger (32) in einer senkrecht zu der Oberfläche (22) der Grundplatte (20) verlaufenden Projektion vollständig umschließender zweiter Bereich (26) ausgebildet ist, wobei in dem zweiten Bereich (26) die Oberfläche (22) der Grundplatte (20) vollständig mit dem Haftmittel (70) bedeckt ist,
**dadurch gekennzeichnet, dass**
das Haftmittel (70) in dem ersten Bereich (24) und in dem zweiten Bereich (26) im Wesentlichen eine einheitliche Schichtdicke aufweist,
- ein Unterschied der Schichtdicke des Haftmittels zwischen dem ersten Bereich und dem zweiten Bereich kleiner als 20% ist,
die Schichtdicke (H) des Haftmittels (70) in dem ersten Bereich im Vergleich zu dem zweiten Bereich (26) durch den Fügeprozess der Solarzelleneinheit (30) mit der Grundplatte (20) sich verringert, und die Breite (B) des zweiten Bereichs (26) mindestens 3 mm beträgt,
um mittels des Haftmittels (70) in dem zweiten Bereich (26) einen elektrisch isolierenden Rahmen herzustellen.

2. Solarzellenmodul (10) nach Anspruch 1, **dadurch gekennzeichnet, dass** jeder zweite Bereich (26) einen an den Träger (32) angrenzenden inneren Rand und einen den zweiten Bereich (26) umschließenden äußeren Rand aufweist, wobei eine parallel zu der Oberfläche (22) der Grundplatte (20) gemessene Breite (B) zwischen dem inneren Rand und dem äußeren Rand mindestens 5 mm beträgt.

3. Solarzellenmodul (10) nach Anspruch 1 oder Anspruch 2, **dadurch gekennzeichnet, dass** das den zweiten Bereich (26) bedeckende Haftmittel (70) eine Dicke (H) über der Oberfläche (22) der Grundplatte (20) von mindestens 0,05 mm aufweist.

4. Solarzellenmodul (10) nach einem oder mehreren der vorangegangenen Ansprüche, **dadurch gekennzeichnet, dass** der Träger (32) jeder Solarzelleneinheit (30) ein keramisches Material umfasst oder aus einem keramischen Material besteht.

5. Solarzellenmodul (10) nach einem der Ansprüche 1 bis 3, **dadurch gekennzeichnet, dass** der Träger (32) jeder Solarzelleneinheit (30) einen elektrisch isolierten Metallkern aufweist.

6. Solarzellenmodul (10) nach einem oder mehreren der vorangegangenen Ansprüche, **dadurch gekennzeichnet, dass** der Träger (32) jeder Solarzelleneinheit (30) eine von mindestens vier Kanten umschlossene Oberseite (34) aufweist, wobei mindestens zwei Kontaktflächen (38.1, 38.2, 38.3) entlang einer ersten Kante (34.1) auf der Oberseite (34) des Trägers (32) angeordnet sind und der Halbleiterkörper (50) zwischen den mindestens zwei Kontaktflächen (38.1, 38.2, 38.3) und einer der ersten Kante (34.1) gegenüberliegenden Kante angeordnet ist.

7. Solarzellenmodul (10) nach Anspruch 6, **dadurch gekennzeichnet, dass** auf der Oberseite (34) des Trägers (32) jeder Solarzelleneinheit (30) drei Kontaktflächen (38.1, 38.2, 38.3) entlang der ersten Kante (34.1) angeordnet sind.

8. Solarzellenmodul (10) nach einem oder mehreren der vorangegangenen Ansprüche, **dadurch gekennzeichnet, dass** das sekundäre optische Element (60) jeder Solarzelleneinheit (30) linsenförmig mit einer dem Halbleiterkörper abgewandten konvexen Oberfläche oder trichterförmig ausgebildet ist.

9. Solarzellenmodul (10) nach einem oder mehreren der vorangegangenen Ansprüche, **dadurch gekennzeichnet, dass** das sekundäre optische Element (60) jeder Solarzelleneinheit (30) vier Ausbuchtungen (68) aufweist, wobei die Unterseite der Ausbuchtungen (68) in einer ersten Höhe über einer Unterseite (62) auf einem seitlichen Oberflächenbereich des jeweiligen sekundären optischen Elements (60) angeordnet sind, in einer senkrecht zu der Unterseite (62) verlaufenden Projektion über die Unterseite (62) hinausragen und entlang eines parallel zu der Unterseite (62) des optischen Elements (60) verlaufenden Umfangs des sekundären optischen Elements (60) gleichmäßig verteilt sind.

10. Solarzellenmodul (10) nach Anspruch 9, **dadurch gekennzeichnet, dass** die Oberseite (34) des Trägers (32) jeder Solarzelleneinheit (30) von vier Kanten begrenzt ist und das sekundäre optische Elemente (60) jeder Solarzelleneinheit (30) so auf dem Träger (32) der Solarzelleneinheit (30) angeordnet ist, dass eine zwei einander gegenüberliegende Ausbuchtungen (68) verbindende Gerade mit den Kanten der Oberseite (34) des Trägers (32) einen Winkel zwischen 35° und 55° einschließt.

11. Solarzellenmodul (10) nach einem oder mehreren der vorangegangenen Ansprüche, **dadurch gekennzeichnet, dass** die zweiten Bereiche von zwei unmittelbar benachbarten Solarzelleneinheiten zueinander beabstandet sind.

12. Solarzellenmodul (10) nach einem oder mehreren der vorangegangenen Ansprüche, **dadurch gekennzeichnet, dass** wenigstens zwei benachbarte Solarzelleneinheiten mittels eines bügelartigen Schaltdrahtes (100) miteinander in Serie verschaltet sind.

13. Solarzellenmodul (10) nach Anspruch 12, **dadurch gekennzeichnet, dass** der Schaltdraht (100) umfasst oder besteht aus einem einzelnen Runddraht oder der Schaltdraht (100) umfasst oder besteht aus einem massiven Flachbanddraht oder der Schaltdraht (100) umfasst oder besteht aus mehreren Adern.

14. Solarzellenmodul (10) nach Anspruch 12 oder Anspruch 13, **dadurch gekennzeichnet, dass** der Schaltdraht (100) mit den Kontaktflächen (38.1, 38.2, 38.3) kraftschlüssig verbunden ist und eine elektrische Verbindung mit den Kontaktflächen (38.1, 38.2, 38.3) aufweist.

15. Solarzellenmodul (10) nach einem der Ansprüche 12 bis 14, **dadurch gekennzeichnet, dass** der Schaltdraht (100) u-förmig ausgebildet ist und der Schaltdraht (100) an jedem Ende einen parallel zu der Oberfläche des Trägers (32) ausgebildeten Anschlussbereich (110) aufweist.

16. Solarzellenmodul (10) nach einem der Ansprüche 12 bis 14, **dadurch gekennzeichnet, dass** der Schaltdraht (100) keine isolierende Ummantelung und einen Querschnitt von 0,8 mm² aufweist.

## Claims

1. Solar cell module (10) consisting of a plurality of solar cell units (30) arranged on a surface (22) of a metallic or predominantly metallic base plate (20), wherein
- each solar cell unit (30) comprises a support (32) with an upper side (34) and a lower side (36), a semiconductor body (50), which is arranged on the upper side (34) of the support (32) and is constructed as a solar cell, and a plurality of contact surfaces and a secondary optical element (60), which is arranged in the semiconductor body (50), wherein the parts, which are arranged on the upper side (34) of the support (32) or at the lower side (36) of the support (32), of the solar cell unit (30) do not project laterally beyond the support,
wherein the support (32) is of plate-shaped construction,
- wherein the support (32) of each solar cell unit (30) respectively covers a first region (24) of the surface (22) of the base plate (20) and the lower side (36) of each support (32) is connected by non-positive couple by means of a thermally conductive and electrically insulating adhesive (70) with the first region (24) of the surface (22) of the base plate (20),
- wherein the respective solar cell unit (30) is connected by non-positive couple with the base plate (20) only in the first region, and
a second region (26) entirely surrounding the support (32) in a projection, which extends perpendicularly to the surface (22) of the base plate (20), is formed, wherein in the second region (26) the surface (22) of the base plate (20) is entirely covered by the adhesive (70), **characterised in that**
the adhesive (70) has a substantially uniform layer thickness in the first region (24) and in the second region (26),
- a difference of the layer thickness of the adhesive between the first region and the second region is less than 20%,
the layer thickness (H) of the adhesive (70) in the first region reduces by comparison with the second region (26) by the joining process of the solar cell unit (30) to the base plate (20) and the width (B) of the second region (26) is at least 3 millimetres so as to produce an electrically insulating frame by means of the adhesive (70) in the second region (26).

2. Solar cell module (10) according to claim 1, **characterised in that** each second region (26) has an inner edge adjoining the support (32) and an outer edge surrounding the second region (26), wherein a width (B), which is measured parallel to the surface (22) of the base plate (20), between the inner edge and the outer edge is at least 5 millimetres.

3. Solar cell module (10) according to claim 1 or claim 2, **characterised in that** the adhesive (70) covering the second region (26) has a thickness (H) of at least 0.05 millimetres over the surface (22) of the base plate (20).

4. Solar cell module (10) according to one or more of the preceding claims, **characterised in that** the support (32) of each solar cell unit (30) comprises a ceramic material or consists of a ceramic material.

5. Solar cell module (10) according to any one of claims 1 to 3, **characterised in that** the support (32) of each solar cell unit (30) has an electrically insulated metal core.

6. Solar cell module (10) according to one or more of the preceding claims, **characterised in that** the support (32) of each solar cell unit (30) has an upper side (34) enclosed by at least four edges, wherein at least two contact surfaces (38.1, 38.2, 38.3) are arranged along a first edge (34.1) on the upper side (34) of the support (32) and the semiconductor body (50) is arranged between the at least two contact surfaces (38.1, 38.2, 38.3) and an edge opposite the first edge (34.1).

7. Solar cell module (10) according to claim 6, **characterised in that** three contact surfaces (38.1, 38.2, 38.3) are arranged along the first edge (34.1) on the upper side (34) of the support (32) of each solar cell unit (30).

8. Solar cell module (10) according to one or more of the preceding claims, **characterised in that** the secondary optical element (60) of each solar cell unit (30) is formed to be lens-shaped with a convex surface remote from the semiconductor body or is formed to be funnel-shaped.

9. Solar cell module (10) according to one or more of the preceding claims, **characterised in that** the secondary optical element (60) of each solar cell unit (30) has four bulges (68), wherein the lower sides of the bulges (68) are arranged at a first height above a lower side (62) on a lateral surface region of the respective secondary optical element (60), project beyond the lower side (62) in a projection extending perpendicularly to the lower side (62) and are uniformly distributed along a circumference, which extends parallel to the lower side (62) of the optical element (60), of the secondary optical element (60).

10. Solar cell module (10) according to claim 9, **characterised in that** the upper side (34) of the support (32) of each solar cell unit (30) is bounded by four edges and the secondary optical element (60) of each solar cell unit (30) is so arranged on the support (32) of the solar cell unit (30) that a straight line connecting two mutually opposite bulges (68) includes an angle between 35° and 55° with the edges of the upper side (34) of the support (32).

11. Solar cell module (10) according to one or more of the preceding claims, **characterised in that** the second regions of two directly adjacent solar cell units are spaced from one another.

12. Solar cell module (10) according to one or more of the preceding claims, **characterised in that** at least two adjacent solar cell units are connected together in series by means of a yoke-like switch wire (100).

13. Solar cell module (10) according to claim 12, **characterised in that** the switch wire (100) comprises or consists of a single round wire or the switch wire (100) comprises or consists of a solid flat strip wire or the switch wire (100) comprises or consists of several strands.

14. Solar cell module (10) according to claim 12 or claim 13, **characterised in that** the switch wire (100) is connected by non-positive couple with the contact surfaces (38.1, 38.2, 38.3) and has an electrical connection with the contact surfaces (38.1, 38.2, 38.3).

15. Solar cell module (10) according to any one of claims 12 to 14, **characterised in that** the switch wire (100) is of U-shaped configuration and the switch wire (100) has at each end a connecting region (110) formed parallel to the surface of the support (32).

16. Solar cell module (10) according to any one of claims 12 to 14, **characterised in that** the switch wire (100) does not have an insulating sheathing and has a cross-section of 0.8 square millimetres.

## Revendications

1. Module de cellules solaires (10), composé de plusieurs unités de cellules solaires (30) disposées sur une surface (22) d'une plaque de base métallique ou principalement métallique (20),
dans lequel chaque unité de cellules solaires (30) comprend un support (32) qui présente une face supérieure (34) et une face inférieure (36), un corps à semi-conducteur (50) disposé sur la face supérieure (34) du support (32) et réalisé sous la forme d'une cellule solaire et plusieurs surfaces de contact et un élément optique secondaire (60) disposé sur le corps à semi-conducteur (50),
dans lequel les parties de l'unité de cellules solaires (30) disposées sur la face supérieure (34) du support (32) ou sur la face inférieure (36) du support (32) ne font pas saillie latéralement à partir du support,
dans lequel le support (32) est réalisé en forme de plaque,
dans lequel le support (32) de chaque unité de cellules solaires (30) recouvre respectivement une première zone (24) de la surface (22) de la plaque de base (20) et la face inférieure (36) de chaque support (32) est reliée par force à la première zone (24) de la surface (22) de la plaque de base (20) au moyen d'un agent adhésif (70) thermo-conducteur et électriquement isolant,
dans lequel l'unité de cellules solaires (30) respective n'est reliée par force à la plaque de base (20) que dans la première zone, et
une seconde zone (26) qui entoure entièrement le support (32) dans une projection qui s'étend perpendiculairement à la surface (22) de la plaque de base (20) est prévue, dans lequel dans la seconde zone (26) la surface (22) de la plaque de base (20) est entièrement recouverte de l'agent adhésif (70),
**caractérisé en ce que**
l'agent adhésif (70) présente dans la première zone (24) et dans la seconde zone (26) pour l'essentiel une épaisseur de couche uniforme,
une différence d'épaisseur de couche de l'agent adhésif entre la première zone et la seconde zone est inférieure à 20 %,
l'épaisseur de couche (H) de l'agent adhésif (70) dans la première zone se réduit en comparaison de la seconde zone (26) du fait du processus d'assemblage de l'unité de cellules solaires (30) à la plaque de base (20), et la largeur (B) de la seconde zone (26) atteint au moins 3 mm, dans le but de fabriquer un cadre électriquement isolant dans la seconde zone (26) au moyen de l'agent adhésif (70).

2. Module de cellules solaires (10) selon la revendication 1, **caractérisé en ce que** chaque seconde zone (26) présente un bord intérieur adjacent au support (32) et un bord extérieur qui entoure la seconde zone (26), dans lequel une largeur (B) mesurée parallèlement à la surface (22) de la plaque de base (20) entre le bord intérieur et le bord extérieur atteint au moins 5 mm.

3. Module de cellules solaires (10) selon la revendication 1 ou la revendication 2, **caractérisé en ce que** l'agent adhésif (70) qui recouvre la seconde zone (26) présente une épaisseur (H) sur la surface (22) de la plaque de base (20) qui est égale à au moins 0,05 mm.

4. Module de cellules solaires (10) selon une ou plusieurs des revendications précédentes, **caractérisé en ce que** le support (32) de chaque unité de cellules solaires (30) comprend un matériau céramique ou est constitué d'un matériau céramique.

5. Module de cellules solaires (10) selon l'une quelconque des revendications 1 à 3, **caractérisé en ce que** le support (32) de chaque unité de cellules solaires (30) comprend un noyau métallique isolé électriquement.

6. Module de cellules solaires (10) selon une ou plusieurs des revendications précédentes, **caractérisé en ce que** le support (32) de chaque unité de cellules solaires (30) présente une face supérieure (34) entourée par au moins quatre arêtes, dans lequel au moins deux surfaces de contact (38.1, 38.2, 38.3) sont disposées le long d'une première arête (34.1) sur la face supérieure (34) du support (32) et le corps à semi-conducteur (50) est disposé entre lesdites au moins deux surfaces de contact (38.1, 38.2, 38.3) et une arête opposée à la première arête (34.1).

7. Module de cellules solaires (10) selon la revendication 6, **caractérisé en ce que** trois surfaces de contact (38.1, 38.2, 38.3) sont disposées le long de la première arête (34.1) sur la face supérieure (34) du support (32) de chaque unité de cellules solaires (30).

8. Module de cellules solaires (10) selon une ou plusieurs des revendications précédentes, **caractérisé en ce que** l'élément optique secondaire (60) de chaque unité de cellules solaires (30) est réalisé de manière lenticulaire avec une surface convexe opposée au corps à semi-conducteur ou en forme d'entonnoir.

9. Module de cellules solaires (10) selon une ou plusieurs des revendications précédentes, **caractérisé en ce que** l'élément optique secondaire (60) de chaque unité de cellules solaires (30) présente quatre renflements (68), dans lequel les faces inférieures des renflements (68) sont disposées à une première hauteur au-dessus d'une face inférieure (62) sur une zone de surface latérale de l'élément optique secondaire (60) respectif, font saillie à partir de la face inférieure (62) dans une projection qui s'étend perpendiculairement à la face inférieure (62) et sont réparties uniformément le long d'une périphérie de l'élément optique secondaire (60) qui s'étend parallèlement à la face inférieure (62) de l'élément optique (60).

10. Module de cellules solaires (10) selon la revendication 9, **caractérisé en ce que** la face supérieure (34) du support (32) de chaque unité de cellules solaires (30) est délimitée par quatre arêtes et l'élément optique secondaire (60) de chaque unité de cellules solaires (30) est disposé sur le support (32) de l'unité de cellules solaires (30), de sorte qu'une droite qui relie deux renflements (68) opposés l'un à l'autre forme avec les arêtes de la face supérieure (34) du support (32) un angle qui est compris entre 35° et 55°.

11. Module de cellules solaires (10) selon une ou plusieurs des revendications précédentes, **caractérisé en ce que** les secondes zones de deux unités de cellules solaires immédiatement voisines sont espacées l'une de l'autre.

12. Module de cellules solaires (10) selon une ou plusieurs des revendications précédentes, **caractérisé en ce qu'**au moins deux unités de cellules solaires voisines sont branchées l'une à l'autre en série par l'intermédiaire d'un fil de connexion de type étrier (100).

13. Module de cellules solaires (10) selon la revendication 12, **caractérisé en ce que** le fil de connexion (100) comprend ou est constitué d'un fil rond individuel ou le fil de connexion (100) comprend ou est constitué d'un fil plat massif ou le fil de connexion (100) comprend ou est constitué de plusieurs brins.

14. Module de cellules solaires (10) selon la revendication 12 ou la revendication 13, **caractérisé en ce que** le fil de connexion (100) est relié par force aux surfaces de contact (38.1, 38.2, 38.3) et présente une liaison électrique avec les surfaces de contact (38.1, 38.2, 38.3).

15. Module de cellules solaires (10) selon l'une quelconque des revendications 12 à 14, **caractérisé en ce que** le fil de connexion (100) est réalisé en forme de u et le fil de connexion (100) présente à chaque extrémité une zone de raccordement (110) qui est réalisée parallèlement à la surface du support (32).

16. Module de cellules solaires (10) selon l'une quelconque des revendications 12 à 14, **caractérisé en ce que** le fil de connexion (100) ne présente pas d'enrobage isolant et présente une section transversale qui est égale à 0,8 mm².
